# EUROPÄISCHE PATENTSCHRIFT

(11) **EP 3 413 424 B1**
(45) Veröffentlichungstag und Bekanntmachung des Hinweises auf die Patenterteilung: **23.12.2020**
(21) Anmeldenummer: 17175383.3
(22) Anmeldetag: 09.06.2017
(51) Int. Cl.: A01G 20/43, H01M 10/44, H01M 10/48, A01G 3/053, H02J 7/00

(54) **VERFAHREN ZUM ERMITTELN EINER INFORMATION ZUM BETREIBEN EINES AKKUMULATORS, VERFAHREN ZUM ERMITTELN VON ZEITDAUERN ZUM AUFLADEN VON VERSCHIEDENEN AKKUMULATOREN UND ELEKTRISCHES GARTEN- UND/ODER FORSTGERÄTESYSTEM**
METHOD FOR DETERMINING AN ITEM OF INFORMATION FOR OPERATING A BATTERY, METHOD FOR DETERMINING DIFFERENT TIMES FOR CHARGING DIFFERENT BATTERIES AND ELECTRIC GARDENING AND/OR FOREST SYSTEM
PROCÉDÉ DE DÉTERMINATION D'UNE INFORMATION DESTINÉE AU FONCTIONNEMENT D'UN ACCUMULATEUR, PROCÉDÉ DE DÉTERMINATION DE DURÉES DE CHARGE DE DIFFÉRENTS ACCUMULATEURS ET SYSTÈME D'APPAREIL FORESTIER ET/OU DE JARDIN ÉLECTRIQUE

(43) Veröffentlichungstag der Anmeldung: 12.12.2018
(73) Patentinhaber: Andreas Stihl AG & Co. KG, 71336 Waiblingen (DE)
(72) Erfinder: Trinkle, Simon, 73667 Kaisersbach (DE); Roitsch, Tommy, 71334 Waiblingen (DE)
(74) Vertreter: Patentanwälte Ruff, Wilhelm, Beier, Dauster & Partner mbB

(56) Entgegenhaltungen:
- EP-A1- 2 082 638
- US-A1- 2011 197 389
- US-A1- 2016 165 795

## Beschreibung

### ANWENDUNGSGEBIET UND STAND DER TECHNIK

Die Erfindung bezieht sich auf ein Verfahren zum Ermitteln einer Information zum Betreiben eines Akkumulators, ein Verfahren zum Ermitteln von Zeitdauern zum Aufladen von verschiedenen Akkumulatoren mit einem solchen Verfahren und ein elektrisches Garten- und/oder Forstgerätesystem mit mindestens einem Akkumulator zum Ausführen eines solchen Verfahrens.

Ein Verfahren zum Ermitteln einer Information zum Betreiben eines Akkumulators und ein elektrisches Garten- und/oder Forstgerätesystem mit einem Akkumulator sind bekannt.

Insbesondere ist aus der US 2016/0165795 A1 ein Roboterrasenmäher mit einer Energiequelle in Form einer Batterie bekannt. Mittels eines mobilen Geräts kann ein Benutzer ein Mähen eines Gebiets bestätigen. Eine projektierte verbleibende Zeit bis zur Fertigstellung wird ausgegeben. Die projektierte Zeit bis zur Fertigstellung kann auf einer verbleibenden Mähfläche basieren. Des Weiteren kann die verbleibende Zeit auf einer verbleibenden Energiemenge der Batterie basieren. Falls erforderlich, werden eine Zeit zum Zurückkehren des Roboterrasenmähers zu einer Dockingstation und ein Aufladen bei der verbleibenden Zeit berücksichtigt.

### AUFGABE UND LÖSUNG

Der Erfindung liegt als Aufgabe die Bereitstellung eines Verfahrens zum Ermitteln einer Information zum Betreiben eines Akkumulators zugrunde, das verbesserte Eigenschaften aufweist, insbesondere mehr Funktionalitäten. Des Weiteren liegt der Erfindung als Aufgabe die Bereitstellung eines Verfahrens zum Ermitteln von Zeitdauern zum Aufladen von verschiedenen Akkumulatoren mit einem solchen Verfahren und eines elektrischen Garten- und/oder Forstgerätesystems mit mindestens einem Akkumulator zum Ausführen eines solchen Verfahrens zugrunde.

Die Erfindung löst diese Aufgabe durch die Bereitstellung eines Verfahrens mit den Merkmalen des Anspruchs 1. Des Weiteren wird die der Erfindung zugrundeliegende Aufgabe durch ein Verfahren mit den Merkmalen des Anspruchs 9 und ein elektrisches Garten- und/oder Forstgerätesystem mit den-Merkmalen des Anspruchs 11 gelöst. Vorteilhafte Weiterbildungen und/oder Ausgestaltungen der Erfindung sind in den abhängigen Ansprüchen beschrieben.

Das erfindungsgemäße Verfahren ist zum, insbesondere automatischen, Ermitteln einer Information zum Betreiben, insbesondere zum Aufladen, eines Akkumulators ausgebildet. Der Akkumulator ist zur, insbesondere elektrischen, Antriebsenergieversorgung eines elektrisch angetriebenen Garten- und/oder Forstgeräts ausgebildet. Das Verfahren weist die Schritte auf: a) Ermitteln oder Vorgeben eines, insbesondere spezifischen, Arbeitseinsatzes des elektrisch angetriebenen Garten- und/oder Forstgeräts. b) Ermitteln oder Bestimmen eines, insbesondere spezifischen, Energiebedarfs des Garten- und/oder Forstgeräts aus dem ermittelten Arbeitseinsatz. c) Ermitteln oder Bestimmen eines Energieinhalts des Akkumulators. d) Vergleichen des ermittelten Energiebedarfs mit dem ermittelten Energieinhalt. e) Ermitteln oder Bestimmen und Ausgeben der, insbesondere spezifischen, Information zum Betreiben, insbesondere zum Aufladen, des Akkumulators basierend auf dem Vergleich. Der Schritt e) weist auf: Ermitteln oder Bestimmen einer, insbesondere spezifischen, Energiemenge zum Aufladen des Akkumulators zur Erreichung des ermittelten Energiebedarfs, insbesondere falls der Energiebedarf größer als der Energieinhalt ist, insbesondere basierend auf dem Vergleich. Ermitteln oder Bestimmen und Ausgeben der, insbesondere spezifischen, Information zum Betreiben, insbesondere zum Aufladen, des Akkumulators basierend auf der ermittelten Energiemenge.

Das Verfahren kann einem Benutzer des elektrisch angetriebenen Garten- und/oder Forstgeräts ermöglichen, Entscheidungen, insbesondere spezifische Entscheidungen, bezüglich des Akkumulators, des Garten- und/oder Forstgeräts und/oder des Arbeitseinsatzes zu treffen.

Als Akkumulator kann ein wiederaufladbarer Speicher für elektrische Energie auf elektrochemischer Basis bezeichnet werden. Insbesondere kann der Schritt a) aufweisen: Auswählen des Arbeitseinsatzes aus einer hinterlegten Anzahl von Arbeitseinsätzen. Der Energieinhalt des Akkumulators kann als Restenergie oder Ladezustand bezeichnet werden. Es kann sein, dass zur Deckung des Energiebedarfs des Garten- und/oder Forstgeräts für den Arbeitseinsatz der Akkumulator nicht vollständig aufgeladen zu sein und/oder zu werden braucht. Es kann ausreichen, dass der Akkumulator, insbesondere nur, teilweise aufgeladen zu sein und/oder zu werden braucht. Insbesondere falls der Energiebedarf gleich oder kleiner als der Energieinhalt ist, kann dies ausgegeben werden.

Die Energiemenge zum Aufladen des Akkumulators braucht nicht gleich der Differenz des Energieinhalts von dem Energiebedarf zu sein. Die Energiemenge kann größer als die Differenz sein, insbesondere wegen eines Aufladewirkungsgrads kleiner oder schlechter 100 Prozent. Die Energiemenge zum Aufladen des Akkumulators kann gleich Null sein, insbesondere falls der Energiebedarf gleich oder kleiner als der Energieinhalt ist. Insbesondere kann beim Ermitteln der Information eine Betriebsgrenze des Akkumulators zum Aufladen und/oder eine Betriebsgrenze eines Ladegeräts oder Laders zum Aufladen des Akkumulators berücksichtigt werden, insbesondere falls der Energiebedarf größer als der Energieinhalt ist.

Der Schritt b) kann zeitgleich mit dem Schritt a) oder zeitlich nach diesem ausgeführt werden. Der Schritt c) kann zeitgleich mit den Schritten/dem Schritt a) und/oder b), zeitlich nach oder vor diesen/diesem ausgeführt werden. Der Schritt d) kann zeitgleich mit den Schritten/dem Schritt b) und/oder c) oder zeitlich nach diesen/diesem ausgeführt werden. Der Schritt e) kann zeitgleich mit dem Schritt d) oder zeitlich nach diesem ausgeführt werden.

In einer Weiterbildung der Erfindung weist der Arbeitseinsatz des elektrisch angetriebenen Garten- und/oder Forstgeräts einen Flächeninhalt, eine Länge und/oder eine Anzahl von Schnitten eines zu bearbeitenden, insbesondere spezifischen, Objekts auf. Dies kann ein relativ einfaches Ermitteln des Arbeitseinsatzes ermöglichen. Das Objekt kann einen Boden, insbesondere einen unversiegelten Boden, eine Grünfläche, insbesondere eine Wiese, einen Rasen und/oder ein Beet mit Blumen oder anderen Pflanzen, eine Anzahl von Sträuchern oder Stauden, eine Hecke und/oder eine Anzahl von Bäumen aufweisen. Zusätzlich oder alternativ kann der Arbeitseinsatz eine, insbesondere voraussichtliche, Gerätelaufzeit aufweisen.

In einer Ausgestaltung der Erfindung weist der Schritt a) auf: Bewegen, insbesondere automatisches Bewegen, oder Führen eines Positionsbestimmungsgeräts zur Bestimmung von Positionskoordinaten entlang des zu bearbeitenden Objekts. Bestimmen von Positionskoordinaten mittels des Positionsbestimmungsgeräts während des Bewegens. Ermitteln des Flächeninhalts, der Länge und/oder der Anzahl von Schnitten des zu bearbeitenden Objekts basierend auf den bestimmten Positionskoordinaten. Dies kann ein besonders einfaches Ermitteln des Arbeitseinsatzes ermöglichen. Insbesondere kann das Positionsbestimmungsgerät einen Satelliten-Positionsbestimmungsempfänger, ein Lokales-Positionierungssystemgerät, ein Trägheitspositionsbestimmungsgerät und/oder ein Odometriepositionsbestimmungsgerät aufweisen. Zusätzlich oder alternativ können Positionskoordinaten auf andere Art und Weise bestimmt werden. Insbesondere können Positionskoordinaten aus einer Datenbank, wie beispielsweise dem Internet, bestimmt und/oder ausgewählt werden. Weiter zusätzlich oder alternativ kann mindestens ein Bild von dem Objekt aufgenommen werden und/oder mindestens ein von dem Objekt aufgenommenes Bild kann ausgewählt werden, insbesondere durch den Benutzer. Der Flächeninhalt, die Länge und/oder die Anzahl von Schnitten können/kann basierend auf dem aufgenommenen Bild bestimmt werden. Insbesondere können Positionskoordinaten basierend auf dem aufgenommenen Bild bestimmt werden. Weiter zusätzlich oder alternativ können/kann der Flächeninhalt, die Länge und/oder die Anzahl von Schnitten, insbesondere durch den Benutzer, vorgegebenen werden. In einer Weiterbildung der Erfindung weist die Information eine Zeitdauer zum Aufladen des Akkumulators auf. Dies kann dem Benutzer ermöglichen zu erkennen, wie lange er auf den Akkumulator beziehungsweise auf sein Aufladen warten muss. Die Zeitdauer kann sekundengenau, minutengenau oder in Zeitabschnitten ausgegeben werden, insbesondere in Form von maximal 5 Minuten, minimal 5 Minuten und/oder maximal 15 Minuten, minimal 15 Minuten und/oder maximal 30 Minuten, minimal 30 Minuten und/oder maximal 1 Stunde, minimal 1 Stunde und/oder maximal 2 Stunden sowie minimal 2 Stunden. Die Zeitdauer zum Aufladen des Akkumulators kann gleich Null sein, insbesondere falls der Energiebedarf gleich oder kleiner als der Energieinhalt ist. Insbesondere kann die Zeitdauer aus der Energiemenge, soweit ermittelt, unter Berücksichtigung eines Aufladens des Akkumulators ermittelt werden. Insbesondere kann eine Betriebsgrenze des Akkumulators zum Aufladen und/oder eine Betriebsgrenze des Ladegeräts, soweit vorhanden, zum Aufladen des Akkumulators berücksichtigt werden. Verschiedene Ladegeräte, wie ein Standardladegerät oder ein Schnellladegerät, können verschieden lang zum Aufladen des Akkumulators brauchen. Das Verfahren kann als Ladedauerprognose bezeichnet werden.

In einer Weiterbildung der Erfindung wird im Schritt e) die Information optisch, akustisch und/oder haptisch ausgegeben. Dies kann dem Benutzer eine relativ gute Wahrnehmung der Information ermöglichen. Insbesondere kann das optische Ausgeben ein Anzeigen aufweisen. Das haptische Ausgeben kann ein Vibrieren aufweisen.

In einer Weiterbildung der Erfindung weist der Schritt c) auf: Messen, insbesondere automatisches Messen, einer elektrischen Eigenschaft des Akkumulators und/oder einer elektrischen Eigenschaft zum Aufladen des Akkumulators. Insbesondere kann/können die elektrische/n Eigenschaft/en eine Spannung, insbesondere eine Ruhespannung im Ruhezustand, und/oder einen Strom aufweisen. Das Messen kann mittels des Garten- und/oder Forstgeräts und/oder des Ladegeräts zum Aufladen des Akkumulators, soweit vorhanden, erfolgen. Insbesondere kann das Garten- und/oder Forstgerät das Ladegerät aufweisen beziehungsweise das Ladegerät kann in das Garten- und/oder Forstgerät integriert sein. Zusätzlich oder alternativ kann das Messen mittels des Akkumulators selbst beziehungsweise eines mit dem Akkumulator fest verbauten Messgeräts erfolgen. Weiter zusätzlich oder alternativ kann der Energieinhalt des Akkumulators mittels Ermitteln einer vergangenen Gerätelaufzeit und/oder Ladezeit seit einer vergangenen vollständigen Aufladung des Akkumulators und/oder einer Kapazität des Akkumulators ermittelt werden. In anderen Worten: der Energieinhalt kann im Betrieb durch Wh-Integration beziehungsweise Coulomb-Counting mitgeführt werden.

In einer Weiterbildung der Erfindung weist das Verfahren den Schritt auf: h) Erfassen, insbesondere automatisches Erfassen, eines Energieverbrauchs des elektrisch angetriebenen Garten- und/oder Forstgeräts für den ermittelten Arbeitseinsatz, insbesondere während des Arbeitseinsatzes. Beim nächsten Ausführen des Verfahrens im Schritt b) den, insbesondere nächsten, Energiebedarf des Garten- und/oder Forstgeräts aus dem ermittelten, insbesondere nächsten, Arbeitseinsatz basierend auf dem erfassten Energieverbrauch, insbesondere für den vergangenen Arbeitseinsatz, ermitteln. Dies kann ein relativ genaueres, insbesondere benutzerspezifisches und/oder objektspezifisches, Ermitteln des Energiebedarfs und somit ein relativ genaueres Ermitteln der Information ermöglichen. Insbesondere kann der Energieverbrauch von einer Arbeitsweise des Benutzers des Garten- und/oder Forstgeräts und/oder dem Objekt abhängig sein. Der Energieverbrauch kann wie der Energieinhalt mittels Messen und/oder Ermitteln einer Gerätelaufzeit ermittelt werden, wie zuvor beschrieben. Zusätzlich und/oder alternativ kann der Arbeitseinsatz erfasst werden. Vor einem ersten Arbeitseinsatz kann der Energiebedarf basierend auf einem werkseitigen Grundwert ermittelt werden.

In einer Weiterbildung der Erfindung weist das Verfahren die Schritte auf: f) Aufladen des Akkumulators. g) Ausgeben einer weiteren Information, wenn der Energiegehalt des Akkumulators zur Deckung des Energiebedarfs ausreicht. Dies kann dem Benutzer ermöglichen wahrzunehmen, dass er mit dem Arbeitseinsatz beginnen kann. Der Schritt f) kann zeitgleich mit den Schritten/dem Schritt a), b), c), d) und/oder e), zeitlich nach oder vor diesen/diesem ausgeführt werden. Der Schritt g) kann zeitgleich mit den Schritten/dem Schritt b), c), d), e) und/oder f) oder zeitlich nach diesen/diesem ausgeführt werden. Insbesondere können/kann während des Aufladens die Schritte/der Schritt c), d) und/oder e) ausgeführt oder wiederholt werden, insbesondere mehrfach.

In einer Weiterbildung der Erfindung ist der Akkumulator zur Antriebsenergieversorgung verschiedener elektrisch angetriebener Garten- und/oder Forstgeräte ausgebildet. Das Verfahren weist den Schritt auf: Ermitteln von Arbeitseinsätzen der verschiedenen elektrisch angetriebenen Garten- und/oder Forstgeräte. Ausgeben einer Information zum Betreiben, insbesondere zum Aufladen, des Akkumulators für die Arbeitseinsätze. Dies kann dem Benutzer ermöglichen zu entscheiden, welchen Arbeitseinsatz er ausführen möchte beziehungsweise mit welchem Garten- und/oder Forstgerät er arbeiten möchte und/oder in welcher Reihenfolge er die Arbeitseinsätze ausführen möchte. Die Garten- und/oder Forstgeräte können für den gleichen Arbeitseinsatz und/oder für das gleiche Objekt geeignet sein. Insbesondere können die Garten- und/oder Forstgeräte baugleich sein. Der Akkumulator kann als auswechselbarer Akkumulator ausgebildet sein. Die Garten- und/oder Forstgeräte können jeweils zur auswechselbaren beziehungsweise lösbaren Aufnahme des Akkumulators ausgebildet sein, insbesondere zur zerstörungsfreien und/oder werkzeugfreien Aufnahme.

Des Weiteren bezieht sich die Erfindung auf ein Verfahren zum, insbesondere automatischen, Ermitteln von Zeitdauern zum Aufladen von verschiedenen Akkumulatoren. Die verschiedenen Akkumulatoren sind jeweils zur Antriebsenergieversorgung des elektrisch angetriebenen Garten- und/oder Forstgeräts ausgebildet. Das erfindungsgemäße Verfahren weist die Schritte auf: Ermitteln einer jeweiligen Zeitdauer zum Aufladen eines jeweiligen Akkumulators nach dem zuvor beschriebenen Verfahren, insbesondere zur Erreichung des Energieinhalts zur Deckung des Energiebedarfs für den Arbeitseinsatz des elektrisch angetriebenen Garten- und/oder Forstgeräts. Vergleichen der Zeitdauern der verschiedenen Akkumulatoren. Ermitteln des Akkumulators, welcher die kürzeste Zeitdauer zum Aufladen hat. Ausgeben des Akkumulators, welcher die kürzeste Zeitdauer zum Aufladen hat. Dies kann dem Benutzer ermöglichen zu entscheiden, welchen Akkumulator er benutzen möchte und/oder welchen Akkumulator er aufladen möchte, insbesondere falls nur ein Ladegerät zur Verfügung steht. Alternativ können mehrere Ladegeräte zur Verfügung stehen. Die verschiedenen Akkumulatoren können jeweils mit einzelnen oder mehreren der Ladegeräte kompatibel sein, insbesondere mittels dieser aufgeladen werden. Es kann möglich sein, dass ein Akkumulator, obwohl seine zu ladende Energiemenge größer sein kann als die eines anderen Akkumulators, eine kürzere Zeitdauer als der andere Akkumulator aufweisen kann. Insbesondere wenn der eine Akkumulator mit einer größeren Leistung als der andere Akkumulator geladen werden kann oder darf. Insbesondere kann der eine Akkumulator mit einem Schnellladegerät kompatibel sein und der andere Akkumulator kann, insbesondere nur, mit einem Standardladegerät kompatibel sein. Die Zeitdauern können für verschiedene Akkumulatoren-Lader-Paarungen ermittelt werden. Die Paarung mit der kürzesten Zeitdauer kann ausgegeben werden. Die Akkumulatoren können baugleich sein. Zusätzlich oder alternativ können die verschiedenen Akkumulatoren verschiedene Maximalkapazitäten aufweisen. Die Akkumulatoren können jeweils als auswechselbare Akkumulatoren ausgebildet sein. Das Garten- und/oder Forstgerät kann zur auswechselbaren Aufnahme, insbesondere mindestens, eines der Akkumulatoren ausgebildet sein. Optional kann die kürzeste Zeitdauer ausgegeben werden.

In einer Weiterbildung der Erfindung sind die verschiedenen Akkumulatoren jeweils zur Antriebsenergieversorgung verschiedener elektrisch angetriebener Garten- und/oder Forstgeräte ausgebildet. Das Verfahren weist die Schritte auf: Ermitteln von Arbeitseinsätzen der verschiedenen elektrisch angetriebenen Garten- und/oder Forstgeräte. Ermitteln einer jeweiligen Zeitdauer zum Aufladen eines jeweiligen Akkumulators für die Arbeitseinsätze. Ermitteln von Gesamtzeitdauern zum Aufladen der verschiedenen Akkumulatoren für verschiedene Akkumulatoren-Geräte-Paarungen basierend auf den Zeitdauern. Vergleichen der verschiedenen Gesamtzeitdauern der verschiedenen Akkumulatoren-Geräte-Paarungen. Ermitteln der Akkumulatoren-Geräte-Paarung, welche die kürzeste Gesamtzeitdauer zum Aufladen hat. Ausgeben der Akkumulatoren-Geräte-Paarung, welche die kürzeste Gesamtzeitdauer zum Aufladen hat. Dies kann ermöglichen, dass der Benutzer oder mehrere Benutzer relativ kurz auf die Akkumulatoren warten muss/müssen. Insbesondere können für die verschiedenen Akkumulatoren-Geräte-Paarungen die verschiedenen Akkumulatoren den verschiedenen Garten- und/oder Forstgeräten zugeordnet sein. Eine Mehrzahl der Akkumulatoren kann einer Mehrzahl der Garten- und/oder Forstgeräte entsprechen, größer und/oder kleiner als diese sein. Insbesondere können die Gesamtzeitdauern durch aufsummieren der Zeitdauern ermittelt werden. Optional kann die kürzeste Gesamtzeitdauer ausgegeben werden. Zusätzlich oder alternativ können für die verschiedenen Akkumulatoren-Geräte-Paarungen die Zeitdauern verglichen werden, insbesondere zeitgleich oder zeitlich nach dem Ermitteln der Zeitdauern. Die Akkumulatoren-Geräte-Paarung kann ermittelt werden, welche die kürzesten Zeitdauern zum Aufladen hat, und diese Akkumulatoren-Geräte-Paarung kann ausgegeben werden. In anderen Worten kann die Akkumulatoren-Geräte-Paarung ermittelt werden, für welche eine maximale Zeitdauer am kürzesten ist. Die sich daraus ergebende Gesamtzeitdauer braucht nicht die kürzeste Gesamtzeitdauer zu sein. Weiter zusätzlich oder alternativ können die Zeitdauern und/oder die Gesamtzeitdauern für verschiedene Akkumulatoren-Lader-Paarungen und diese ermittelt, verglichen und/oder ausgegeben werden. Dies kann als verschiedene Akkumulatoren-Geräte-Lader-Paarungen bezeichnet werden.

Außerdem bezieht sich die Erfindung auf ein elektrisches Garten- und/oder Forstgerätesystem. Das erfindungsgemäße elektrische Garten- und/oder Forstgerätesystem weist das mindestens eine elektrisch angetriebene Garten- und/oder Forstgerät und den mindestens einen Akkumulator auf. Der Akkumulator ist zur Antriebsenergieversorgung des Garten- und/oder Forstgeräts ausgebildet. Das elektrische Garten- und/oder Forstgerätesystem ist zum Ausführen des zuvor beschriebenen Verfahrens ausgebildet. Das Garten- und/oder Forstgerätesystem kann die gleichen Vorteile wie das zuvor beschriebene Verfahren ermöglichen. Insbesondere kann das Garten- und/oder Forstgerät einen Elektromotor aufweisen, welcher dazu ausgebildet sein kann, von dem Akkumulator mit Antriebsenergie versorgt zu werden. Das Garten- und/oder Forstgerät kann zum Ausführen einzelner Schritte oder aller Schritte des zuvor beschriebenen Verfahrens ausgebildet sein. Zusätzlich oder alternativ kann der Akkumulator zum Ausführen einzelner Schritte oder aller Schritte des zuvor beschriebenen Verfahrens ausgebildet sein, insbesondere zum Ermitteln seines Energieinhalts.

In einer Weiterbildung der Erfindung weist das elektrische Garten- und/oder Forstgerätesystem mindestens ein Ladegerät auf. Das Ladegerät ist zum Aufladen des mindestens einen Akkumulators ausgebildet. Insbesondere kann das Ladegerät zum Ermitteln des Energieinhalts des Akkumulators und/oder anderer Schritte des zuvor beschriebenen Verfahrens ausgebildet sein.

In einer Weiterbildung der Erfindung weist das elektrische Garten- und/oder Forstgerätesystem ein mobiles oder portables Ermittlungsgerät oder Erfassungsgerät auf. Das mobile Ermittlungsgerät ist zum Ermitteln des Arbeitseinsatzes des mindestens einen elektrisch angetriebenen Garten- und/oder Forstgeräts ausgebildet. Des Weiteren ist das Ermittlungsgerät zum Ermitteln des Energiebedarfs des Garten- und/oder Forstgeräts aus dem ermittelten Arbeitseinsatz ausgebildet. Außerdem ist das Ermittlungsgerät zum Vergleichen des ermittelten Energiebedarfs mit dem ermittelten Energieinhalt des mindestens einen Akkumulators ausgebildet. Weiter ist das Ermittlungsgerät zum Ermitteln und Ausgeben der Information zum Betreiben, insbesondere zum Aufladen, des Akkumulators basierend auf dem Vergleich ausgebildet. Dies kann dem Benutzer ein einfaches Ausführen des Verfahrens ermöglichen. Insbesondere kann das Ermittlungsgerät von dem Garten- und/oder Forstgerät, dem Akkumulator und/oder dem Ladegerät, soweit vorhanden, verschieden sein. Das Ermittlungsgerät kann ein Smartphone und/oder ein Tablet aufweisen oder sein. Insbesondere kann das Ermittlungsgerät zum Ermitteln der Energiemenge zum Aufladen des Akkumulators zur Erreichung des Energiebedarfs ausgebildet sein. Zudem kann das Ermittlungsgerät zum Ermitteln und Ausgeben der Information zum Betreiben, insbesondere zum Aufladen, des Akkumulators basierend auf der ermittelten Energiemenge ausgebildet sein.

In einer Weiterbildung der Erfindung weist das mindestens eine elektrisch angetriebene Garten- und/oder Forstgerät eine Säge, einen Hoch-Entaster, einen Freischneider, eine Heckenschere, einen Heckenschneider, ein Blasgerät, einen Laubbläser, eine Astschere, einen Trennschleifer, ein Kehrgerät, eine Kehrwalze, eine Kehrbürste, einen Rasenmäher, einen Vertikutierer und/oder eine Grasschere auf.

### KURZBESCHREIBUNG DER ZEICHNUNGEN

Weitere Vorteile und Aspekte der Erfindung ergeben sich aus den Ansprüchen und aus der nachfolgenden Beschreibung von bevorzugten Ausführungsbeispielen der Erfindung, die nachfolgend anhand der Figuren erläutert sind. Dabei zeigen:
- Fig. 1: ein Ablaufdiagramm eines erfindungsgemäßen Verfahrens,
- Fig. 2: eine schematische Ansicht eines elektrisch angetriebenen Garten- und/oder Forstgeräts und eines Akkumulators eines erfindungsgemäßen elektrischen Garten- und/oder Forstgerätesystems,
- Fig. 3: eine schematische Ansicht eines weiteren elektrisch angetriebenen Garten- und/oder Forstgeräts und eines weiteren Akkumulators des elektrischen Garten- und/oder Forstgerätesystems,
- Fig. 4: eine schematische Ansicht eines Ladegeräts und eines weiteren Akkumulators des elektrischen Garten- und/oder Forstgerätesystems,
- Fig. 5: eine schematische Ansicht eines mobilen Ermittlungsgeräts des elektrischen Garten- und/oder Forstgerätesystems und
- Fig. 6: eine Draufsicht auf ein mittels des elektrischen Garten- und/oder Forstgerätesystems zu bearbeitendes Objekt.

### DETAILLIERTE BESCHREIBUNG DER AUSFÜHRUNGSBEISPIELE

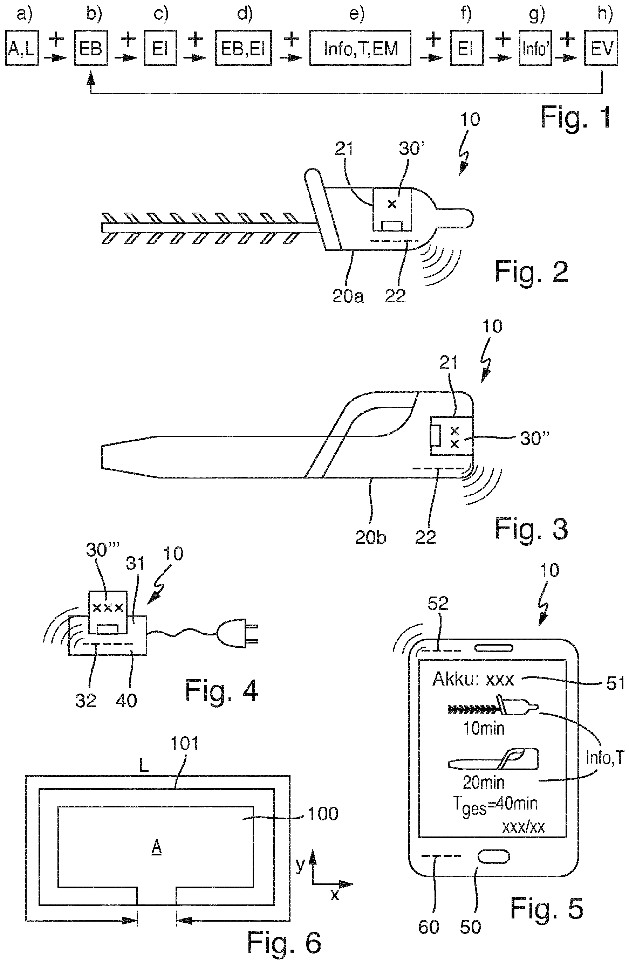

Fig. 1 zeigt ein erfindungsgemäßes Verfahren zum Ermitteln einer Information Info zum Betreiben, insbesondere zum Aufladen, eines Akkumulators 30', 30", 30"', wie in Fig. 2 bis 4 zu erkennen. Der Akkumulator 30', 30", 30'" ist zur elektrischen Antriebsenergieversorgung eines elektrisch angetriebenen Garten- und/oder Forstgeräts 20a, 20b ausgebildet. Das Verfahren weist die Schritte auf: a) Ermitteln eines Arbeitseinsatzes des elektrisch angetriebenen Garten- und/oder Forstgeräts 20a, 20b. b) Ermitteln eines Energiebedarfs EB des Garten- und/oder Forstgeräts 20a, 20b aus dem ermittelten Arbeitseinsatz. c) Ermitteln eines Energieinhalts EI des Akkumulators 30', 30", 30'". d) Vergleichen des ermittelten Energiebedarfs EB mit dem ermittelten Energieeinhalt EI. e) Ermitteln und Ausgeben der Information Info zum Betreiben, insbesondere zum Aufladen, des Akkumulators 30', 30", 30"` basierend auf dem Vergleich.

Somit ermöglicht das Verfahren einem Benutzer des Garten- und/oder Forstgeräts 20a, 20b, Entscheidungen bezüglich des Akkumulators 30', 30", 30'", des Garten- und/oder Forstgeräts 20a, 20b und/oder des Arbeitseinsatzes zu treffen.

Fig. 2 bis 5 zeigen ein erfindungsgemäßes elektrisches Garten- und/oder Forstgerätesystem 10. Das Garten- und/oder Forstgerätesystem 10 weist das mindestens eine elektrisch angetriebene Garten- und/oder Forstgerät 20a, 20b auf. Im gezeigten Ausführungsbeispiel weist das Garten- und/oder Forstgerätesystem 10 zwei Garten- und/oder Forstgeräte 20a, 20b auf, wie in Fig. 2 und 3 zu erkennen. In alternativen Ausführungsbeispielen kann das Garten- und/oder Forstgerätesystem nur ein einziges Garten- und/oder Forstgerät oder mehr als zwei Garten- und/oder Forstgeräte aufweisen. Das in Fig. 2 gezeigte Garten- und/oder Forstgerät 20a weist eine Heckenschere auf oder ist eine Heckenschere. Das in Fig. 3 gezeigte Garten- und/oder Forstgerät 20b weist einen Laubbläser auf oder ist ein Laubbläser. Des Weiteren weist das Garten- und/oder Forstgerätesystem 10 den mindestens einen Akkumulator 30', 30", 30'" auf. Im gezeigten Ausführungsbeispiel weist das Garten- und/oder Forstgerätesystem 10 drei Akkumulatoren 30', 30", 30'" auf. In alternativen Ausführungsbeispielen kann das Garten- und/oder Forstgerätesystem nur einen einzige Akkumulator, zwei Akkumulatoren oder mehr als drei Akkumulatoren aufweisen. Die verschiedenen Akkumulatoren 30', 30", 30'" sind jeweils zur Antriebsenergieversorgung des mindestens einen elektrisch angetriebenen Garten- und/oder Forstgeräts 20a, 20b ausgebildet. Insbesondere sind die Akkumulatoren 30', 30", 30'" baugleich. Im Detail sind die Akkumulatoren 30', 30", 30'" jeweils als auswechselbarer Akkumulator ausgebildet. Die Garten- und/oder Forstgeräte 20a, 20b sind jeweils zur auswechselbaren Aufnahme eines der Akkumulatoren 30', 30", 30'" ausgebildet. Anders formuliert: die Garten- und/oder Forstgeräte 20a, 20b weisen jeweils einen Akkumulatorschacht 21 zur Aufnahme eines der Akkumulatoren 30', 30", 30'" auf. In alternativen Ausführungsbeispielen kann der Akkumulator fest in das Garten- und/oder Forstgerät eingebaut sein. Anders formuliert, kann der Akkumulator, insbesondere nur, unter Verwendung von Werkzeug von dem Garten- und/oder Forstgerät gelöst werden. Das elektrische Garten- und/oder Forstgerätesystem 10 ist zum Ausführen des zuvor beschriebenen Verfahrens ausgebildet.

Außerdem weist das elektrische Garten- und/oder Forstgerätesystem 10 mindestens ein Ladegerät 40 auf. Im gezeigten Ausführungsbeispiel weist das Garten- und/oder Forstgerätesystem 10 nur ein einziges Ladegerät 40 auf. In alternativen Ausführungsbeispielen kann das Garten- und/oder Forstgerätesystem mehr als ein Ladegerät aufweisen. Das Ladegerät 40 ist zum Aufladen des mindestens einen Akkumulators 30', 30", 30'" ausgebildet. Im Detail ist das Ladegerät 40 zur auswechselbaren Aufnahme eines der Akkumulatoren 30', 30", 30'" ausgebildet. Anders formuliert: das Ladegerät 40 weist einen Akkumulatorschacht 31 zur Aufnahme eines der Akkumulatoren 30', 30", 30'" auf.

Im gezeigten Ausführungsbeispiel ist das mindestens eine Garten- und/oder Forstgerät 20a, 20b zum Ermitteln des Energieinhalts EI des Akkumulators 30', 30", 30'" ausgebildet, welcher in es aufgenommen oder eingesetzt ist. Das Ladegerät 40 ist zum Ermitteln des Energieinhalts EI des Akkumulators 30'" ausgebildet, welcher in es aufgenommen oder eingesetzt ist. In alternativen Ausführungsbeispielen kann es ausreichen, wenn entweder das Garten- und/oder Forstgerät oder das Ladegerät zum Ermitteln des Energieinhalts des Akkumulators ausgebildet sein kann. Weiter zusätzlich oder alternativ kann der Akkumulator selbst zum Ermitteln seines Energieinhalts ausgebildet sein. In anderen Worten kann das elektrische Garten- und/oder Forstgerätesystem ein Messgerät aufweisen, wobei das Messgerät zum Ermitteln des Energieinhalts des Akkumulators ausgebildet sein kann und insbesondere fest mit dem Akkumulator verbaut sein kann.

Weiter weist das elektrische Garten- und/oder Forstgerätesystem 10 ein mobiles Ermittlungsgerät 50 auf, wie in Fig. 5 zu erkennen. Das mobile Ermittlungsgerät 50 ist zum Ermitteln des Arbeitseinsatzes des mindestens einen elektrisch angetriebenen Garten- und/oder Forstgeräts 20a, 20b ausgebildet. Des Weiteren ist das Ermittlungsgerät 50 zum Ermitteln des Energiebedarfs EB des Garten- und/oder Forstgeräts 20a, 20b aus dem ermittelten Arbeitseinsatz ausgebildet. Außerdem ist das Ermittlungsgerät 50 zum Vergleichen des ermittelten Energiebedarfs EB mit dem ermittelten Energieinhalt EI des mindestens einen Akkumulators 30', 30", 30'" ausgebildet. Weiter ist das Ermittlungsgerät 50 zum Ermitteln und Ausgeben der Information Info zum Betreiben, insbesondere zum Aufladen, des Akkumulators 30', 30", 30'" basierend auf dem Vergleich ausgebildet. Im gezeigten Ausführungsbeispiel ist das Ermittlungsgerät 50 ein Smartphone mit einem Touchscreen 51.

Im Detail weist das mindestens eine Garten- und/oder Forstgerät 20a, 20b eine Geräteübertragungseinheit auf, insbesondere in Form einer Antenne. Des Weiteren weist das Ladegerät 40 eine Ladeübertragungseinheit 32 auf, insbesondere in Form einer Antenne. Außerdem weist das Ermittlungsgerät 50 eine Ermittlungsübertragungseinheit 52 auf, insbesondere in Form einer Antenne. Die Geräteübertragungseinheit 22 und die Ermittlungsübertragungseinheit 52 sind zum Zusammenwirken miteinander und zum, insbesondere drahtlosen, Übertragen des ermittelten Energieinhalts EI des Akkumulators 30', 30" ausgebildet. Die Ladeübertragungseinheit 32 und die Ermittlungsübertragungseinheit 52 sind zum Zusammenwirken miteinander und zum, insbesondere drahtlosen, Übertragen des ermittelten Energieinhalts EI des Akkumulators 30' ausgebildet. In alternativen Ausführungsbeispielen kann der Akkumulator selbst eine Akkumulatorübertragungseinheit aufweisen, insbesondere in Form einer Antenne. Die Akkumulatorübertragungseinheit und die Ermittlungsübertragungseinheit können zum Zusammenwirken miteinander und zum, insbesondere drahtlosen, Übertragen des ermittelten Energieinhalts des Akkumulators ausgebildet sein. Grundsätzlich oder generell kann eine jeweilige Übertragungseinheit eine Funkschnittstelle aufweisen.

Zudem weist das elektrische Garten- und/oder Forstgerätesystem 10 ein Positionsbestimmungsgerät 60 in Form eines Satelliten-Positionsbestimmungsempfängers zur Bestimmung von Positionskoordinaten x, y entlang eines zu bearbeitenden Objekts 100, 101 auf. Im gezeigten Ausführungsbeispiel weist das Ermittlungsgerät 50 das Positionsbestimmungsgerät 60 auf beziehungsweise das Positionsbestimmungsgerät 60 ist in das Ermittlungsgerät 50 integriert. In alternativen Ausführungsbeispielen braucht das Positionsbestimmungsgerät nicht in das Ermittlungsgerät integriert zu sein. Insbesondere kann das mindestens eine Garten- und/oder Forstgerät das Positionsbestimmungsgerät aufweisen.

Im gezeigten Ausführungsbeispiel weist der Arbeitseinsatz des in Fig. 2 gezeigten Garten- und/oder Forstgeräts 20a in Form der Heckenschere eine, insbesondere spezifische, Länge L des Objekts 101 in Form einer Hecke auf, wie in Fig. 6 zu erkennen. Der Arbeitseinsatz des in Fig. 3 gezeigten Garten- und/oder Forstgeräts 20b in Form des Laubbläsers weist einen, insbesondere spezifischen, Flächeninhalt A des Objekts 100 in Form eines Bodens mit Blättern auf.

Im Detail weist der Schritt a) auf: Bewegen des Positionsbestimmungsgeräts 60 zur Bestimmung von Positionskoordinaten x, y entlang des, insbesondere mindestens einen, zu bearbeitenden Objekts 100, 101. Bestimmen von Positionskoordinaten x, y mittels des Positionsbestimmungsgeräts 60 während des Bewegens. Ermitteln des Flächeninhalts A des Objekts 100 und der Länge L des Objekts 101 basierend auf den bestimmten Positionskoordinaten x, y. Im gezeigten Ausführungsbeispiel können der Flächeninhalt A und die Länge L zusammen durch Bewegen des Positionsbestimmungsgeräts 60 entlang des Objekts 101 in Form der Hecke ermittelt werden. Insbesondere kann das Verfahren den Schritt aufweisen: Hinterlegen des mindestens einen ermittelten Arbeitseinsatzes. Im gezeigten Ausführungsbeispiel weist das Ermittlungsgerät 50 eine nicht dargestellte Speichereinheit zur Hinterlegung des mindestens einen ermittelten Arbeitseinsatzes auf.

Im gezeigten Ausführungsbeispiel weist der Schritt e) auf: Ermitteln einer Energiemenge EM zum Aufladen des Akkumulators 30', 30", 30'" zur Erreichung des ermittelten Energiebedarfs EB. Ermitteln und Ausgeben der Information Info zum Betreiben, insbesondere zum Aufladen, des Akkumulators 30', 30", 30'" basierend auf der ermittelten Energiemenge EM.

Das Ermittlungsgerät 50 ist zum Ermitteln der Energiemenge EM zum Aufladen des Akkumulators 30', 30", 30'" zur Erreichung des Energiebedarfs EB ausgebildet. Zudem ist das Ermittlungsgerät 50 zum Ermitteln und Ausgeben der Information Info zum Betreiben, insbesondere zum Aufladen, des Akkumulators 30', 30", 30'" basierend auf der ermittelten Energiemenge EM ausgebildet.

Des Weiteren weist die Information Info eine Zeitdauer T zum Aufladen des mindestens einen Akkumulators 30', 30", 30'" auf.

Im Schritt e) wird die Information Info beziehungsweise die Zeitdauer T optisch ausgegeben beziehungsweise angezeigt, insbesondere mittels des Ermittlungsgeräts 50 in Form des Smartphones mit dem Touchscreen, wie in Fig. 5 zu erkennen.

Im gezeigten Ausführungsbeispiel wird das Verfahren automatisch ausgeführt. Insbesondere kann das Ausführen mittels des Ermittlungsgeräts 50 ausgelöst werden. Im Schritt a) werden die Arbeitseinsätze der verschiedenen Garten- und/oder Forstgeräte 20a, 20b ermittelt, wie zuvor beschrieben. Im Schritt b) werden die Energiebedarfe EB für die verschiedenen Arbeitseinsätze ermittelt. Im Schritt c) werden die Energieinhalte EI der verschiedenen Akkumulatoren 30', 30", 30'" ermittelt. Im Detail weist der Schritt c) auf: Messen einer elektrischen Eigenschaft jedes der Akkumulatoren 30', 30", 30'" und/oder einer elektrischen Eigenschaft zum Aufladen jedes der Akkumulatoren 30', 30", 30'". Im Schritt d) werden die verschiedenen Energiebedarfe EB mit den ermittelten Energieinhalten EI verglichen, insbesondere für verschiedene Akkumulatoren-Geräte-Paarungen. Im Schritt e) wird die Information Info zum Betreiben, insbesondere in Form von jeweiligen Zeitdauern T zum Aufladen, eines jeweiligen Akkumulators 30', 30", 30'" basierend auf dem Vergleich ermittelt, insbesondere für die verschiedenen Akkumulatoren-Geräte-Paarungen. Im Detail weist der Schritt e) auf: Ermitteln verschiedener Energiemengen EM zum Aufladen der verschiedenen Akkumulatoren 30', 30", 30'" zur Erreichung der ermittelten Energiebedarfe EB, insbesondere für die verschiedenen Akkumulatoren-Geräte-Paarungen. Ermitteln der Information Info zum Betreiben, insbesondere in Form von jeweiligen Zeitdauern T zum Aufladen, eines jeweiligen Akkumulators 30', 30", 30'" basierend auf den ermittelten Energiemengen EM, insbesondere für die verschiedenen Akkumulatoren-Geräte-Paarungen. Außerdem werden die jeweiligen Zeitdauern T der verschiedenen Akkumulatoren 30', 30", 30'" verglichen. Weiter wird der Akkumulator 30', 30", 30'" ermittelt und ausgegeben, welcher die kürzeste Zeitdauer T zum Aufladen hat. Zudem wird im Schritt e) die Information Info in Form der Zeitdauern T zum Aufladen des Akkumulators 30', 30", 30'" mit der kürzesten Zeitdauer T für die Arbeitseinsätze ausgegeben.

Vorliegend ist jeder Energiebedarf EB größer als jeder Energieinhalt EI. Jedoch ist der Energieinhalt EI des Akkumulators 30'" am größten. Des Weiteren ist der Energiebedarf EB des Garten- und/oder Forstgeräts 20a in Form der Heckenschere am kleinsten. Infolgedessen ist die Zeitdauer T zum Aufladen des Akkumulators 30'" für den Arbeitseinsatz des Garten- und/oder Forstgeräts 20a am kürzesten, hier 10 Minuten. Der Akkumulator 30'" wird in Form einer benutzerlesbaren Bezeichnung beispielsweise von drei Kreuzen und die Information Info beziehungsweise die Zeitdauer T werden mittels des Ermittlungsgeräts 50 ausgegeben. Des Weiteren wird die Information Info beziehungsweise die Zeitdauer T zum Aufladen des Akkumulators 30'" für den Arbeitseinsatz des Garten- und/oder Forstgeräts 20b ausgegeben, hier 20 Minuten. Dies ermöglicht dem Benutzer zu entscheiden, dass er den Arbeitseinsatz des Garten- und/oder Forstgeräts 20b in Form der Heckenschere zuerst ausführen möchte und er den Akkumulator 30'" für diesen Arbeitseinsatz aufladen möchte.

Des Weiteren weist das Verfahren die Schritte auf: f) Aufladen des Akkumulators 30', 30", 30'". g) Ausgeben einer weiteren Information Info', wenn der Energieinhalt EI des Akkumulators 30', 30", 30'" zur Deckung des Energiebedarfs EB ausreicht. Im gezeigten Ausführungsbeispiel braucht der Akkumulator 30'" nicht vollständig für den Arbeitseinsatz des Garten- und/oder Forstgeräts 20b in Form der Heckenschere aufgeladen zu werden.

Wenn der Akkumulator 30'" ausreichend aufgeladen ist, kann er dem Ladegerät 40 entnommen werden und in das Garten- und/oder Forstgerät 20a anstelle des Akkumulators 30' eingesetzt werden. Dann kann der Benutzer mit dem Arbeitseinsatz beginnen, insbesondere kann er das Objekt 101 in Form der Hecke mit dem Garten- und/oder Forstgerät 20a schneiden.

Außerdem weist das Verfahren den Schritt auf: h) Erfassen eines Energieverbrauchs EV des elektrisch angetriebenen Garten- und/oder Forstgeräts 20a, 20b für den ermittelten Arbeitseinsatz, insbesondere während des Arbeitseinsatzes. Beim nächsten Ausführen des Verfahrens im Schritt b) den nächsten Energiebedarf EB des Garten- und/oder Forstgeräts 20a, 20b aus dem ermittelten, insbesondere nächsten, Arbeitseinsatz basierend auf dem erfassten Energieverbrauch EV, insbesondere für den vergangenen Arbeitseinsatz, ermitteln.

Im gezeigten Ausführungsbeispiel ist die Länge L des Objekts 101 in Form der Hecke ermittelt, aber nicht ihre Tiefe. Diese hätte beim Ermitteln des Arbeitseinsatzes durch den Benutzer vorgegeben werden können. Jedoch ist bei einem ersten Arbeitseinsatz der Energiebedarf EB basierend auf einem werkseitigen Grundwert, insbesondere für die Heckentiefe, ermittelt worden. Nach dem Erfassen des Energieverbrauchs EV für den Arbeitseinsatz kann beim nächsten Ausführen des Verfahrens im Schritt b) der Energiebedarf EB für den nächsten, insbesondere gleichen, Arbeitseinsatz relativ genauer ermittelt werden. Insbesondere kann der erfasste Energieverbrauch EV für den Arbeitseinsatz in der Speichereinheit des Ermittlungsgeräts 50 hinterlegt werden und/oder das Ermittlungsgerät 50 kann dazu ausgebildet sein.

Zusätzlich weist das Verfahren den Schritt auf und/oder das Garten- und/oder Forstgerätesystem 10 ist dazu ausgebildet: Ausgeben eines Restarbeitseinsatzes, insbesondere einer Restlaufzeit, einer Restfläche und/oder einer Restlänge. In anderen Worten: Für wieviel Gerätelaufzeit, für wieviel Fläche und/oder für wieviel Länge kann das Garten- und/oder Forstgerät 20a, 20b mit dem Akkumulator 30', 30", 30'" noch genutzt werden beziehungsweise für wieviel Gerätelaufzeit, für wieviel Fläche und/oder für wieviel Länge hält der Energieinhalt EI des Akkumulators noch. In alternativen Ausführungsbeispielen kann das Verfahren den Schritt aufweisen und/oder das Garten- und/oder Forstgerätesystem kann dazu ausgebildet sein: Ausgeben eines Restarbeitseinsatzes, insbesondere einer Restanzahl von Schnitten.

Wenn der Akkumulator 30"' für den Arbeitseinsatz des Garten- und/oder Forstgeräts 20a in Form der Heckenschere dem Ladegerät 40 entnommen ist, ist das Ladegerät 40 frei zum Aufladen eines der Akkumulatoren 30', 30" für den Arbeitseinsatz des Garten- und/oder Forstgeräts 20b in Form des Laubbläsers. Das Verfahren weist die Schritte auf: Ermitteln einer jeweiligen Zeitdauer T zum Aufladen eines jeweiligen Akkumulators 30', 30" nach dem zuvor beschriebenen Verfahren. Vergleichen der Zeitdauern T der verschiedenen Akkumulatoren 30', 30". Ermitteln und Ausgeben des Akkumulators 30', 30", welcher die kürzeste Zeitdauer T zum Aufladen hat.

Vorliegend ist der Energieinhalt EI des Akkumulators 30" mit der Bezeichnung beispielsweise von zwei Kreuzen größer als der Energieinhalt EI des Akkumulators 30' mit der Bezeichnung beispielsweise von einem Kreuz. Infolgedessen ist die Zeitdauer T zum Aufladen des Akkumulators 30" kürzer als die Zeitdauer T zum Aufladen des Akkumulators 30'. Dies wird ausgegeben. Dies ermöglicht dem Benutzer zu entscheiden, dass er den Akkumulator 30" für den Arbeitseinsatz des Garten- und/oder Forstgeräts 20b in Form des Laubbläsers mit dem Ladegerät 40 aufladen möchte. Hier ist die Zeitdauer T zum Aufladen des Akkumulators 30" 30 Minuten.

Weiter weist das Verfahren die Schritte auf: Ermitteln von Gesamtzeitdauern Tges zum Aufladen der verschiedenen Akkumulatoren 30', 30", 30'" für verschiedene Akkumulatoren-Geräte-Paarungen basierend auf den Zeitdauern T. Vergleichen der verschiedenen Gesamtzeitdauern Tges der verschiedenen Akkumulatoren-Geräte-Paarungen. Ermitteln und Ausgeben der Akkumulatoren-Geräte-Paarung, welche die kürzeste Gesamtzeitdauer Tges zum Aufladen hat. Zusätzlich wird die kürzeste Gesamtzeitdauer Tges zum Aufladen ausgegeben. Hier ist die Gesamtzeitdauer Tges die Summe der Zeitdauern T, im Detail 10 Minuten + 30 Minuten = 40 Minuten.

Im gezeigten Ausführungsbeispiel sind die Akkumulatoren 30', 30", 30'" baugleich. In alternativen Ausführungsbeispielen können die Akkumulatoren verschieden aufgebaut sein oder können oder dürfen mit verschiedenen Leistungen geladen werden. Des Weiteren weist im gezeigten Ausführungsbeispiel das Garten- und/oder Forstgerätesystem 10 nur ein einziges Ladegerät 40 auf. In alternativen Ausführungsbeispielen kann das Garten- und/oder Forstgerätesystem mehr als ein Ladegerät aufweisen. Ein Ladegerät kann ein Standardladegerät sein und ein anderes Ladegerät kann ein Schnellladegerät sein. Die verschiedenen Akkumulatoren können jeweils mit einzelnen oder mehreren der Ladegeräte kompatibel sein. Verschiedene Akkumulatoren-Lader-Paarungen können zu verschiedenen Zeitdauern und/oder Gesamtzeitdauern führen. Eine optimale Paarung kann ermittelt werden.

Wie die gezeigten und oben erläuterten Ausführungsbeispiele deutlich machen, stellt die Erfindung ein vorteilhaftes Verfahren zum Ermitteln einer Information zum Betreiben, insbesondere zum Aufladen, eines Akkumulators bereit, das verbesserte Eigenschaften aufweist, insbesondere mehr Funktionalitäten. Insbesondere kann das Verfahren einem Benutzer eines elektrisch angetriebenen Garten- und/oder Forstgeräts ermöglichen, Entscheidungen bezüglich des Akkumulators, des Garten- und/oder Forstgeräts und/oder eines Arbeitseinsatzes zu treffen. Des Weiteren stellt die Erfindung ein Verfahren zum Ermitteln von Zeitdauern zum Aufladen von verschiedenen Akkumulatoren mit einem solchen Verfahren und ein elektrisches Garten- und/oder Forstgerätesystem mit mindestens einem Akkumulator zum Ausführen eines solchen Verfahrens bereit.

## Patentansprüche

1. Verfahren zum Ermitteln einer Information (Info) zum Betreiben eines Akkumulators (30', 30", 30'"), wobei der Akkumulator zur Antriebsenergieversorgung eines elektrisch angetriebenen Garten- und/oder Forstgeräts (20a, 20b) ausgebildet ist, wobei das Verfahren die Schritte aufweist:
- a) Ermitteln eines Arbeitseinsatzes des elektrisch angetriebenen Garten- und/oder Forstgeräts (20a, 20b),
- b) Ermitteln eines Energiebedarfs (EB) des Garten- und/oder Forstgeräts aus dem ermittelten Arbeitseinsatz,
- c) Ermitteln eines Energieinhalts (EI) des Akkumulators (30', 30", 30'"),
- d) Vergleichen des ermittelten Energiebedarfs mit dem ermittelten Energieinhalt und
- e) Ermitteln und Ausgeben der Information (Info) zum Betreiben des Akkumulators basierend auf dem Vergleich,
**dadurch gekennzeichnet, dass**
der Schritt e) aufweist:
- Ermitteln einer Energiemenge (EM) zum Aufladen des Akkumulators (30', 30", 30'") zur Erreichung des ermittelten Energiebedarfs (EB) und
- Ermitteln und Ausgeben der Information (Info) zum Betreiben des Akkumulators basierend auf der ermittelten Energiemenge.

2. Verfahren nach Anspruch 1,
- wobei der Arbeitseinsatz des elektrisch angetriebenen Garten- und/oder Forstgeräts (20a, 20b) einen Flächeninhalt (A), eine Länge (L) und/oder eine Anzahl von Schnitten eines zu bearbeitenden Objekts (100, 101) aufweist.

3. Verfahren nach Anspruch 2,
- wobei der Schritt a) aufweist:
Bewegen eines Positionsbestimmungsgeräts (60) zur Bestimmung von Positionskoordinaten (x, y) entlang des zu bearbeitenden Objekts (100, 101) und Bestimmen von Positionskoordinaten mittels des Positionsbestimmungsgeräts während des Bewegens und
Ermitteln des Flächeninhalts (A), der Länge (L) und/oder der Anzahl von Schnitten des zu bearbeitenden Objekts basierend auf den bestimmten Positionskoordinaten.

4. Verfahren nach einem der vorhergehenden Ansprüche,
- wobei im Schritt e) die Information (Info) optisch, akustisch und/oder haptisch ausgegeben wird.

5. Verfahren nach einem der vorhergehenden Ansprüche,
- wobei der Schritt c) aufweist:
Messen einer elektrischen Eigenschaft des Akkumulators (30', 30", 30'") und/oder einer elektrischen Eigenschaft zum Aufladen des Akkumulators.

6. Verfahren nach einem der vorhergehenden Ansprüche,
wobei das Verfahren den Schritt aufweist:
- h) Erfassen eines Energieverbrauchs (EV) des elektrisch angetriebenen Garten- und/oder Forstgeräts (20a, 20b) für den Arbeitseinsatz und
- beim nächsten Ausführen des Verfahrens im Schritt b) den Energiebedarf (EB) des Garten- und/oder Forstgeräts aus dem ermittelten Arbeitseinsatz basierend auf dem erfassten Energieverbrauch ermitteln.

7. Verfahren nach einem der vorhergehenden Ansprüche,
- wobei das Verfahren die Schritte aufweist:
f) Aufladen des Akkumulators (30"') und
g) Ausgeben einer weiteren Information (Info'), wenn der Energiegehalt (EI) des Akkumulators zur Deckung des Energiebedarfs (EB) ausreicht.

8. Verfahren nach einem der vorhergehenden Ansprüche,
- wobei der Akkumulator (30', 30", 30"') zur Antriebsenergieversorgung verschiedener elektrisch angetriebener Garten- und/oder Forstgeräte (20a, 20b) ausgebildet ist,
- wobei das Verfahren den Schritt aufweist:
Ermitteln von Arbeitseinsätzen der verschiedenen elektrisch angetriebenen Garten- und/oder Forstgeräte (20a, 20b) und Ausgeben einer Information (Info) zum Betreiben des Akkumulators (30', 30", 30'") für die Arbeitseinsätze.

9. Verfahren zum Ermitteln von Zeitdauern (T) zum Aufladen von verschiedenen Akkumulatoren (30', 30", 30"'), wobei die verschiedenen Akkumulatoren jeweils zur Antriebsenergieversorgung eines elektrisch angetriebenen Garten- und/oder Forstgeräts (20a, 20b) ausgebildet sind, wobei das Verfahren die Schritte aufweist:
- Ermitteln einer jeweiligen Zeitdauer (T) zum Aufladen eines jeweiligen Akkumulators (30', 30", 30"') nach einem Verfahren nach einem der vorhergehenden Ansprüche,
- Vergleichen der Zeitdauern der verschiedenen Akkumulatoren,
- Ermitteln des Akkumulators, welcher die kürzeste Zeitdauer zum Aufladen hat, und
- Ausgeben des Akkumulators, welcher die kürzeste Zeitdauer zum Aufladen hat.

10. Verfahren nach Anspruch 9,
- wobei die verschiedenen Akkumulatoren (30', 30", 30'") jeweils zur Antriebsenergieversorgung verschiedener elektrisch angetriebener Garten- und/oder Forstgeräte (20a, 20b) ausgebildet sind,
wobei das Verfahren die Schritte aufweist:
- Ermitteln von Arbeitseinsätzen der verschiedenen elektrisch angetriebenen Garten- und/oder Forstgeräte (20a, 20b),
- Ermitteln einer jeweiligen Zeitdauer (T) zum Aufladen eines jeweiligen Akkumulators (30', 30", 30"`) für die Arbeitseinsätze,
- Ermitteln von Gesamtzeitdauern (Tges) zum Aufladen der verschiedenen Akkumulatoren für verschiedene Akkumulatoren-Geräte-Paarungen basierend auf den Zeitdauern,
- Vergleichen der verschiedenen Gesamtzeitdauern der verschiedenen Akkumulatoren-Geräte-Paarungen,
- Ermitteln der Akkumulatoren-Geräte-Paarung, welche die kürzeste Gesamtzeitdauer zum Aufladen hat, und
- Ausgeben der Akkumulatoren-Geräte-Paarung, welche die kürzeste Gesamtzeitdauer zum Aufladen hat.

11. Elektrisches Garten- und/oder Forstgerätesystem (10) aufweisend:
- mindestens ein elektrisch angetriebenes Garten- und/oder Forstgerät (20a, 20b) und
- mindestens einen Akkumulator (30', 30", 30'"), wobei der Akkumulator zur Antriebsenergieversorgung des Garten- und/oder Forstgeräts ausgebildet ist,
- wobei das elektrische Garten- und/oder Forstgerätesystem (10) zum Ausführen eines Verfahrens nach einem der vorhergehenden Ansprüche ausgebildet ist.

12. Elektrisches Garten- und/oder Forstgerätesystem (10) nach Anspruch 11,
- wobei das elektrische Garten- und/oder Forstgerätesystem (10) mindestens ein Ladegerät (40) aufweist, wobei das Ladegerät zum Aufladen des mindestens einen Akkumulators (30', 30", 30'") ausgebildet ist.

13. Elektrisches Garten- und/oder Forstgerätesystem (10) nach Anspruch 11 oder 12,
- wobei das elektrische Garten- und/oder Forstgerätesystem (10) ein mobiles Ermittlungsgerät (50) aufweist, wobei das mobile Ermittlungsgerät zum Ermitteln eines Arbeitseinsatzes des mindestens einen elektrisch angetriebenen Garten- und/oder Forstgeräts (20a, 20b), zum Ermitteln eines Energiebedarfs (EB) des Garten- und/oder Forstgeräts aus dem ermittelten Arbeitseinsatz, zum Vergleichen des ermittelten Energiebedarfs mit einem ermittelten Energieinhalt (EI) des mindestens einen Akkumulators (30', 30", 30"') und zum Ermitteln und Ausgeben einer Information (Info) zum Betreiben des Akkumulators basierend auf dem Vergleich ausgebildet ist.

14. Elektrisches Garten- und/oder Forstgerätesystem (10) nach einem der Ansprüche 11 bis 13,
- wobei das mindestens eine elektrisch angetriebene Garten- und/oder Forstgerät (20a, 20b) eine Säge, einen Hoch-Entaster, einen Freischneider, eine Heckenschere, einen Heckenschneider, ein Blasgerät, einen Laubbläser, eine Astschere, einen Trennschleifer, ein Kehrgerät, eine Kehrwalze, eine Kehrbürste, einen Rasenmäher, einen Vertikutierer und/oder eine Grasschere aufweist.

## Claims

1. Method for obtaining information (Info) for operating an accumulator (30', 30", 30"'), wherein the accumulator is configured to supply drive energy to an electrically powered gardening and/or forestry apparatus (20a, 20b), the method comprising the steps:
- a) obtaining an employment of the electrically powered gardening and/or forestry apparatus (20a, 20b),
- b) obtaining an energy demand (EB) of the gardening and/or forestry apparatus from the obtained employment,
- c) obtaining an energy content (EI) of the accumulator (30', 30", 30"'),
- d) comparing the obtained energy demand to the obtained energy content, and
- e) obtaining and outputting the information (Info) for operating the accumulator based on the comparison,
**characterized in that**
the step e) comprises:
- obtaining a quantity of energy (EM) for charging the accumulator (30', 30", 30'") to meet the obtained energy demand (EB), and
- obtaining and outputting the information (Info) for operating the accumulator based on the obtained quantity of energy.

2. Method according to claim 1,
- wherein the employment of the electrically powered gardening and/or forestry apparatus (20a, 20b) has a surface area (A), a length (L) and/or a number of cuts of an object (100, 101) to be treated.

3. Method according to claim 2,
- wherein step a) comprises:
moving a position determination device (60) for determining of position coordinates (x, y) along the object (100, 101) to be treated and determining of position coordinates using the position determination device during the movement, and
obtaining the surface area (A), the length (L) and/or the number of cuts of the object to be treated based on the determined position coordinates.

4. Method according to any of the preceding claims,
- wherein in step e) the information (Info) is outputted using optics, acoustics and/or haptics.

5. Method according to any of the preceding claims,
- wherein step c) comprises:
measuring an electric property of the accumulator (30', 30", 30"') and/or an electric property for charging the accumulator.

6. Method according to any of the preceding claims, the method comprising the step:
- h) identifying an energy consumption (EV) of the electrically powered gardening and/or forestry apparatus (20a, 20b) for the employment, and
- during the next carrying out of the method in step b) obtaining the energy demand (EB) of the gardening and/or forestry apparatus from the obtained employment based on the identified energy consumption.

7. Method according to any of the preceding claims,
- the method comprising the steps:
f) charging the accumulator (30"') and
g) outputting of further information (Info'), if the energy content (EI) of the accumulator is sufficient to satisfy the energy demand (EB).

8. Method according to any of the preceding claims,
- wherein the accumulator (30', 30", 30'") is configured to supply drive energy to different electrically powered gardening and/or forestry apparatus (20a, 20b),
- wherein the method comprises the step:
obtaining employments of the different electrically powered gardening and/or forestry apparatus (20a, 20b) and outputting of information (Info) for operating the accumulator (30', 30", 30"') for the employments.

9. Method for obtaining periods of time (T) for charging of different accumulators (30', 30", 30'"), wherein the different accumulators each are configured to supply drive energy to an electrically powered gardening and/or forestry apparatus (20a, 20b), the method comprising the steps:
- obtaining a respective period of time (T) for charging a respective accumulator (30', 30", 30'") according to a method according to any of the preceding claims,
- comparing the periods of time of the different accumulators,
- obtaining the accumulator having the shortest period of time for charging, and
- outputting the accumulator having the shortest period of time for charging.

10. Method according to claim 9,
- wherein the different accumulators (30', 30", 30"') each are configured to supply drive energy to different electrically powered gardening and/or forestry apparatus (20a, 20b),
the method comprising the steps:
- obtaining employments of the different electrically powered gardening and/or forestry apparatus (20a, 20b),
- obtaining a respective period of time (T) for charging a respective accumulator (30', 30", 30'") for the employments,
- obtaining total periods of time (Tges) for charging the different accumulators for different accumulator-apparatus pairs based on the periods of time,
- comparing the different total periods of time of the different accumulator-apparatus pairs,
- obtaining the accumulator-apparatus pair having the shortest total period of time for charging, and
- outputting the accumulator-apparatus pair having the shortest total period of time for charging.

11. Electrical gardening and/or forestry apparatus system (10), comprising:
- at least one electrically powered gardening and/or forestry apparatus (20a, 20b) and
- at least one accumulator (30', 30", 30"'), wherein the accumulator is configured to supply drive energy to the gardening and/or forestry apparatus,
- wherein the electrical gardening and/or forestry apparatus system (10) is configured to carry out a method according to any of the preceding claims.

12. Electrical gardening and/or forestry apparatus system (10) according to claim 11,
- wherein the electrical gardening and/or forestry apparatus system (10) includes at least one charger (40), wherein the charger is configured to charge the at least one accumulator (30', 30", 30'").

13. Electrical gardening and/or forestry apparatus system (10) according to claim 11 or 12,
- wherein the electrical gardening and/or forestry apparatus system (10) includes a mobile determination device (50), wherein the mobile determination device is configured to obtain an employment of the at least one electrically powered gardening and/or forestry apparatus (20a, 20b), to obtain an energy demand (EB) of the gardening and/or forestry apparatus from the obtained employment, to compare the obtained energy demand to an obtained energy content (EI) of the at least one accumulator (30', 30", 30"'), and to obtain and output information (Info) for operating the accumulator based on the comparison.

14. Electrical gardening and/or forestry apparatus system (10) according to any of claims 11 to 13,
- wherein the at least one electrically powered gardening and/or forestry apparatus (20a, 20b) is a saw, a pole pruner, a clearing saw or a brush cutter, a hedge pruner or hedge shears, a hedge trimmer, a blower apparatus, a leaf blower, a lopper, a cutoff grinder, a sweeper apparatus, a sweeper roller, a sweeper brush, a lawn mower, a dethatcher and/or a grass trimmer.

## Revendications

1. Procédé de détermination d'une information (Info) destinée au fonctionnement d'un accumulateur (30', 30", 30"'), l'accumulateur étant réalisé pour l'alimentation en énergie d'entraînement d'un appareil forestier et/ou de jardin à entraînement électrique (20a, 20b), le procédé comprenant les étapes consistant à :
- a) déterminer une mission de travail de l'appareil forestier et/ou de jardin à entraînement électrique (20a, 20b),
- b) déterminer une demande énergétique (EB) de l'appareil forestier et/ou de jardin selon la mission de travail déterminée,
- c) déterminer une teneur énergétique (EI) de l'accumulateur (30', 30", 30"'),
- d) comparer la demande énergétique déterminée à la teneur énergétique déterminée, et
- e) déterminer et sortir l'information (Info) destinée au fonctionnement de l'accumulateur sur la base de la comparaison,
**caractérisé en ce que** l'étape e) comprend :
- la détermination d'une quantité d'énergie (EM) destinée à recharger l'accumulateur (30', 30", 30''') afin d'atteindre la demande énergétique déterminée (EB), et
- déterminer et sortir l'information (Info) destinée au fonctionnement de l'accumulateur sur la base de la quantité d'énergie déterminée.

2. Procédé selon la revendication 1,
- dans lequel la mission de travail de l'appareil forestier et/ou de jardin à entraînement électrique (20a, 20b) présente une superficie (A), une longueur (L) et/ou un nombre de coupes d'un objet à traiter (100, 101).

3. Procédé selon la revendication 2,
- dans lequel l'étape a) comprend :
le déplacement d'un appareil de positionnement (60) pour déterminer des coordonnées de position (x, y) le long de l'objet à traiter (100, 101) et la détermination de coordonnées de position au moyen de l'appareil de positionnement pendant le déplacement, et
la détermination de la superficie (A), de la longueur (L) et/ou du nombre de coupes de l'objet à traiter sur la base des coordonnées de position déterminées.

4. Procédé selon l'une quelconque des revendications précédentes,
- dans lequel à l'étape e), l'information (Info) est sortie de manière optique, acoustique et/ou haptique.

5. Procédé selon l'une quelconque des revendications précédentes,
- dans lequel l'étape c) comprend :
la mesure d'une propriété électrique de l'accumulateur (30', 30", 30''') et/ou d'une propriété électrique pour recharger l'accumulateur.

6. Procédé selon l'une quelconque des revendications précédentes, le procédé comprenant l'étape consistant à :
- h) acquérir une consommation énergétique (EV) de l'appareil forestier et/ou de jardin à entraînement électrique (20a, 20b) pour la mission de travail, et
- à l'exécution suivante du procédé à l'étape b), déterminer la demande énergétique (EB) de l'appareil forestier et/ou de jardin selon la mission de travail déterminée sur la base de la consommation énergétique détectée.

7. Procédé selon l'une quelconque des revendications précédentes,
- le procédé comprenant les étapes consistant à :
f) recharger l'accumulateur (30'''), et
g) sortir une information supplémentaire (Info') si la teneur énergétique (EI) de l'accumulateur est suffisante pour couvrir la demande énergétique (EB).

8. Procédé selon l'une quelconque des revendications précédentes,
- dans lequel l'accumulateur (30', 30", 30''') est réalisé pour alimenter en énergie d'entraînement différents appareils forestiers et/ou de jardin à entraînement électrique (20a, 20b),
- le procédé comprenant l'étape consistant à :
déterminer des missions de travail des différents appareils forestiers et/ou de jardin à entraînement électrique (20a, 20b) et sortir une information (Info) destinée au fonctionnement de l'accumulateur (30', 30", 30''') pour les missions de travail.

9. Procédé de détermination de durées (T) de recharge de différents accumulateurs (30', 30", 30"'), les différents accumulateurs étant respectivement réalisés pour alimenter en énergie d'entraînement un appareil forestier et/ou de jardin à entraînement électrique (20a, 20b), le procédé comprenant les étapes consistant à :
- déterminer une durée (T) respective pour recharger un accumulateur (30', 30", 30''') respectif selon un procédé selon l'une quelconque des revendications précédentes,
- comparer les durées des différents accumulateurs,
- déterminer l'accumulateur présentant la durée de recharge la plus courte, et
- sortir l'accumulateur qui présente la durée de recharge la plus courte.

10. Procédé selon la revendication 9,
- dans lequel les différents accumulateurs (30', 30", 30''') sont respectivement réalisés pour alimenter en énergie d'entraînement différents appareils forestiers et/ou de jardin (20a, 20b) à entraînement électrique,
le procédé comprenant les étapes consistant à :
- déterminer des missions de travail des différents appareils forestiers et/ou de jardin à entraînement électrique (20a, 20b),
- déterminer une durée (T) respective pour recharger un accumulateur (30', 30", 30''') respectif pour les missions de travail,
- déterminer des durées totales (Tges) pour recharger les différents accumulateurs pour différents couples accumulateurs/appareils sur la base des durées,
- comparer les différentes durées totales des différents couples accumulateurs/appareils,
- déterminer le couple accumulateur/appareil qui présente la durée de recharge totale la plus courte, et
- sortir le couple accumulateur/appareil qui présente la durée de recharge totale la plus courte.

11. Système d'appareil forestier et/ou de jardin électrique (10), comprenant :
- au moins un appareil forestier et/ou de jardin à entraînement électrique (20a, 20b), et
- au moins un accumulateur (30', 30", 30'''), l'accumulateur étant réalisé pour l'alimentation en énergie d'entraînement de l'appareil forestier et/ou de jardin,
- le système d'appareil forestier et/ou de jardin électrique (10) étant réalisé pour effectuer un procédé selon l'une quelconque des revendications précédentes.

12. Système d'appareil forestier et/ou de jardin électrique (10) selon la revendication 11,
- le système d'appareil forestier et/ou de jardin électrique (10) présentant au moins un chargeur (40), le chargeur étant réalisé pour recharger ledit au moins un accumulateur (30', 30", 30''').

13. Système d'appareil forestier et/ou de jardin électrique (10) selon la revendication 11 ou 12,
- le système d'appareil forestier et/ou de jardin électrique (10) comprenant un appareil de détermination mobile (50), l'appareil de détermination mobile étant réalisé pour déterminer une mission de travail dudit au moins un appareil forestier et/ou de jardin à entraînement électrique (20a, 20b), pour déterminer une demande énergétique (EB) de l'appareil forestier et/ou de jardin selon la mission de travail déterminée, pour comparer la demande énergétique déterminée à une teneur énergétique déterminée (EI) dudit au moins un accumulateur (30', 30", 30"'), et pour déterminer et sortir une information (Info) destinée au fonctionnement de l'accumulateur sur la base de la comparaison.

14. Système d'appareil forestier et/ou de jardin électrique (10) selon l'une quelconque des revendications 11 à 13,
- ledit au moins un appareil forestier et/ou de jardin à entraînement électrique (20a, 20b) comprenant une scie, une élagueuse, une débroussailleuse, un taille-haie, une cisaille électrique, un appareil de soufflage, un chasse-feuille, un sécateur, une tronçonneuse, une balayeuse, un cylindre balayeur, une brosse de balayage, une tondeuse, un scarificateur et/ou une cisaille à gazon.
